# EUROPÄISCHE PATENTANMELDUNG

(11) **EP 1 262 373 A2**
(43) Veröffentlichungstag der Anmeldung: **04.12.2002**
(21) Anmeldenummer: 02010972.4
(22) Anmeldetag: 16.05.2002
(51) Int. Cl.: B60R 13/10

(54) **Schild mit elektrisch aktivierbarer Leuchtfolie**

(30) Priorität: 01.06.2001 DE 20109237 U; 28.01.2002 DE 20201224 U
(71) Anmelder: FER Fahrzeugelektrik GmbH, 99817 Eisenach (DE)
(72) Erfinder: Tietze, Martin, 99817 Eisenach (DE); Quendt, Peer, Dr., 99817 Eisenach (DE); Gotthardt, Frank, Dr., 99817 Eisenach (DE)
(74) Vertreter: Strasser, Wolfgang, Dipl.-Phys.

(57) **Zusammenfassung**

Ein Schild (1), insbesondere Kraftfahrzeug-Kennzeichenschild, besitzt ein Gehäuse (3), das eine flächenhafte Rückwand (4) umfaßt, die von einem vorstehenden Rand (5) umgeben ist, der eine Lichtdurchtrittsöffnung (7) umschließt, durch die hindurch ein flacher, sich parallel zur Rückwand des Gehäuses erstreckender Symbolträger sichtbar ist, der zur Darstellung von auf ihm befindlichen Symbolen (20) Bereiche unterschiedlicher Transparenz aufweist. Zwischen der Rückwand und dem Symbolträger ist eine elektrisch aktivierbare Leuchtfolie (14) vorgesehen, die den Symbolträger von hinten her durchleuchtet. Zur Erzielung von retroreflektierenden Eigenschaften ist vor der Leuchtfolie und parallel zu dieser eine sich zumindest über erhebliche Teile der Fläche der Lichtaustrittsöffnung erstreckende, für das von hinten kommende Licht zumindest teilweise transparente, für von außen auf sie auffallendes Fremdlicht retroreflektierende Folie (15) angeordnet. Weiterhin sind eine die Lichtaustrittsöffnung verschließende, zumindest bereichsweise transparente Lichtscheibe und zwischen der Innenseite der Lichtscheibe und der ihr zugewandten Oberfläche der retroreflektierenden Folie eine rauhe Schicht vorgesehen.

## Beschreibung

Die Erfindung betrifft ein Schild, insbesondere ein Kraftfahrzeug-Kennzeichenschild der im Oberbegriff von Anspruch 1 genannten Art.

Bei einem unter diesen Oberbegriff fallenden Kraftfahrzeug-Kennzeichenschild, wie es aus dem deutschen Gebrauchsmuster 297 12 954.6 bekannt ist, wird der Symbolträger von einer steifen Kunststoffplatte gebildet, welche in dem als Halterahmen ausgebildeten Gehäuse vor einer als Elektrolumineszenzfolie ausgebildeten, elektrisch aktivierbaren Leuchtfolie angeordnet ist. Die vom Halterahmen umschlossene Lichtdurchtrittsöffnung, durch welche das von der elektrisch aktivierbaren Leuchtfolie im eingeschalteten Zustand abgegebene Licht nach außen tritt, nachdem es den Symbolträger von hinten her durchleuchtet hat, ist nicht weiter verschlossen, da der Symbolträger wegen seiner Steifigkeit von dem vorstehenden Rand des Gehäuses ohne weiteres sicher gehalten werden kann und dadurch auch die hinter ihm liegende elektrisch aktivierbare Leuchtfolie fixiert.

Diese bekannte Anordnung ist insofern vorteilhaft, als durch die elektrisch aktivierbare Leuchtfolie eine direkte Beleuchtung des Hintergrundes der Kennzeichnung erzielt wird, ohne daß eine separat angeordnete Beleuchtung erforderlich ist. Somit ist das bekannte Kennzeichenschild äußerst kompakt und platzsparend.

Nachteilig ist, daß keine steifen, d.h. als Verschluß der Lichtdurchtrittsöffnung geeigneten Kunststoffplatten zur Verfügung stehen, die nicht nur für das von der elektrisch aktivierbaren Leuchtfolie abgegebene, von hinten kommende Licht transparent sondern gleichzeitig für von außen kommendes, auf den Symbolträger auffallendes Fremdlicht retroreflektierend sind, wie dies vom Gesetzgeber insbesondere für Kraftfahrzeug-Kennzeichenschilder verlangt wird, aber auch für andere Schilder, beispielsweise Verkehrsschilder von Vorteil bzw. oder erforderlich ist.

Somit liegt der Erfindung die Aufgabe zugrunde, ein Schild der eingangs genannten Art so weiterzubilden, daß es zusätzlich zu der mit Hilfe einer elektrisch aktivierbaren Leuchtfolie erfolgenden Eigenbeleuchtung auch retroreflektierende Eigenschaften aufweist.

Zur Lösung dieser Aufgabe sieht die Erfindung die im Anspruch 1 zusammengefaßten Merkmale vor.

Ausgangspunkt dieser Lösung ist die Tatsache, daß auf dem Markt Kunststorfolien zur Verfügung stehen (beispielsweise die unter der Handelsmarke 3M Scotchlite von 3M angebotene Folie), die für Licht, das auf ihre Rückseite auftrifft, weitgehend transparent sind, während sie auf ihre Vorderseite auffallendes Licht retroreflektieren. Da diese Folien aber keine Eigensteifigkeit besitzen, können sie nicht in der Weise, wie dies aus dem Stand der Technik bekannt ist, als "Verschluß-Platte" der Lichtaustrittsöffnung des Schildgehäuses dienen, wie dies bei dem Symbolträger des oben diskutierten deutschen Gebrauchsmuster 297 12 954.6 der Fall ist.

Um die elektrisch aktivierbare Leuchtfolie und die vor ihr angeordnete retroreflektierende Folie in ihrer flachen Anlage an der Gehäuserückwand zu stabilisieren, ist es daher erforderlich, die Lichtdurchtrittsöffnung durch eine Lichtscheibe zu verschließen, die für Licht in beiden Richtungen transparent ist und somit primär eine mechanische Haltefunktion erfüllt.

Ohne weitere Maßnahmen ergibt sich dabei aber das Problem, daß sich die retroreflektierende Folie in ihrer flächigen Anlage an die Innenseite der Lichtscheibe über den gesamten Flächenbereich ungleichmäßig dicht anlegt und teilweise sogar ansaugt, so daß auch bei gleichmäßiger Beleuchtung von innen oder außen unterschiedlich helle bzw. dunkle Zonen bzw. Newton-Ringbildungen entstehen. Dies ist nicht nur unschön sondern insbesondere bei Kraftfahrzeug-Kennzeichenschildern unzulässig. Zur Behebung dieser Schwierigkeiten ist gemäß der Erfindung vorgesehen, zwischen der Innenseite der Lichtscheibe und der ihr zugewandten Oberfläche der retroreflektierenden Folie eine rauhe Schicht vorzusehen.

Diese rauhe Schicht kann auf unterschiedliche Weise realisiert werden. Bei einer besonders bevorzugten Ausführungsform ist zwischen der retroreflektierenden Folie und der Lichtscheibe eine weitere, beidseitig rauhe Folie angeordnet, die in beiden Richtungen eine sehr hohe Transparenz besitzt und verhindert, daß sich die retroreflektierende Folie, die dann eine völlig glatte Oberfläche besitzen kann, an die ebenfalls glatte Innenfläche der Lichtscheibe so eng anlegen kann, daß die oben erwähnten optischen Störungen entstehen.

Alternativ zu dieser zusätzlichen Folie ist es auch möglich, die erfindungsgemäße rauhe Schicht durch eine rauhe Beschichtung entweder der nach außen weisenden Fläche der retroreflektierenden Folie und/oder der nach innen weisenden Oberfläche der Lichtscheibe zu schaffen.

Ein besonderer Vorteil des erfindungsgemäßen Schildes ist darin zu sehen, daß ein gesonderter Symbolträger nicht mehr zwingend erforderlich ist. Vielmehr können die auf dem Schild darzustellenden Symbole auf jeder der vom Betrachter her gesehen vor der hinteren Oberfläche der retroreflektierenden Folie liegenden Oberflächen, d.h. auf der Vorderseite der retroreflektierenden Folie, der Rück- bzw. Vorderseite der auf beiden Seiten rauhen Folie oder der Rück- bzw.

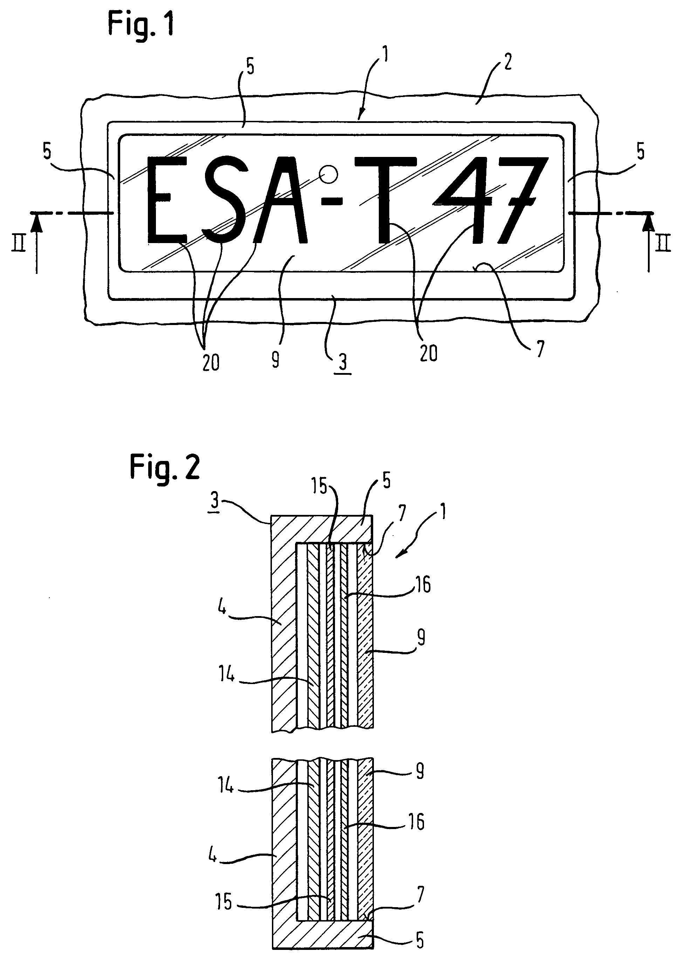

Wie man insbesondere der Fig. 2 entnehmen kann, besitzt das Schild 1 ein Gehäuse 3 mit einer Rückwand 4, die einen um den gesamten Umfang der Rückwand umlaufenden, sich nach vorne, d.h. zum Betrachter hin (in Fig. 2 nach rechts) erstreckenden Rand 5 trägt, der mit der Rückwand 4 einstückig verbunden sein kann.

Der nach vorne vorstehende Rand 5 umschließt eine Lichtdurchlaßöffnung 7, die durch eine transparente Lichtscheibe 9 verschlossen ist. Die Lichtscheibe 9 kann auf irgendeine geeignete Weise am umlaufenden Rand 5 des Gehäuses 3 befestigt sein.

Zwischen der transparenten Lichtscheibe 9 und der Rückwand 4 des Gehäuses 3 befinden sich drei beim vorliegenden Ausführungsbeispiel in etwa die gleiche Fläche wie die Rückwand 4 besitzende Folien 14, 15, 16, die mit ihren Flachseiten aneinander sowie an der Innenfläche der Lichtscheibe 9 und der Innenfläche der Rückwand 4 anliegen. Die in Fig. 2 wiedergegebenen Abstände zwischen den Folien und den Gehäuseteilen 4 und 9 dienen lediglich der Veranschaulichung und sind in Wirklichkeit verschwindend klein.

Bei der hintersten, d.h. in Fig. 2 ganz links befindlichen Folie handelt es sich um eine elektrisch aktivierbare Leuchtfolie 14, die in nicht dargestellter Weise an eine elektrische Energiequelle so angeschlossen ist, daß mit Hilfe eines Schalters elektrische Spannung an sie angelegt werden kann. Sie wird entweder von einer Elektrolumineszenzfolie oder vorzugsweise von einer OLED-Folie gebildet. Im aktivierten Zustand leuchtet die gesamte Folie 14 gleichmäßig und das von ihr ausgehende Licht durchdringt die in Fig. 2 rechts neben ihr angeordneten Folien 15 und 16 sowie die Lichtscheibe 9, so daß in Blickrichtung der Fig. 1 die gesamte Lichtdurchtrittsöffnung 7 von hinten her hell erleuchtet erscheint.

Vor, d.h. in Fig. 2 rechts neben der elektrisch aktivierbaren Leuchtfolie 14 ist eine retroreflektierende Folie 15 so angeordnet, daß ihre retroreflektierende Seite bzw. Fläche nach rechts weist und von außen durch die Lichtscheibe 9 und die Folie 16 hindurch auf sie auffallendes Fremdlicht so retroreflektiert, daß es seinen Weg umkehrt und durch die Folie 16 und die Lichtscheibe 9 in etwa in der gleichen Richtung austritt, in der es eingetreten ist. Zusätzlich ist die retroreflektierende Folie 15 zumindest teilweise transparent, so daß ein erheblicher Teil des von der elektrisch aktivierbaren Leuchtfolie 14 in Richtung der Lichtdurchtrittsöffnung 7 ausgesandten Lichts durch sie hindurchtreten kann.

Zwischen der retroreflektierenden Folie 15 und der Innenseite der Lichtscheibe 9 ist eine-weitere Folie 16 angeordnet, die auf ihren beiden Flachseiten eine leicht aufgerauhte Schicht trägt. Diese Folie 16 ist in sehr hohem Maße transparent, daß sowohl das von Innen kommende Licht der elektrisch aktivierbaren Leuchtfolie 14 als auch von außen kommendes Fremdlicht, sowohl vor als auch nach sei-Vorderseite der Lichtscheibe angebracht werden. Dabei ist es nicht erforderlich, daß sich alle darzustellenden Symbole auf der gleichen Oberfläche befinden.

Besonders bevorzugt ist es, diese Symbole auf einer oder mehreren der Folienoberflächen anzubringen, da diese sehr einfach bedruckt werden können.

Vorteilhaft ist ebenfalls, daß die Folien zwischen der Gehäuserückwand und der Lichtscheibe lose aufeinander liegen und von der Rückwand und der Lichtscheibe gehalten werden, so daß keine zusätzlichen Befestigungsmittel erforderlich sind.

Neben den erwähnten Folien können auch beliebige andere Folien zum Einsatz kommen, welche die erforderlichen optischen Eigenschaften aufweisen, d.h. eine möglichst hohe Transparenz besitzen. Bei der retroreflektierenden Oberfläche der betreffenden Folie ist von Bedeutung, daß sie von außen kommendes Licht unabhängig vom Einfallswinkel in sehr hohem Maße in der jeweiligen Einfallsrichtung reflektiert.

Bei der elektrisch aktivierbaren Leuchtfolie kann es sich um eine Elektrolumineszenzfolie handeln, die in bekannter Weise mit eine Wechselspannung angesteuert wird, die bei einem Kraftfahrzeugkennzeichenschild mit Hilfe eine Vorschaltgerätes aus der Bord-Gleichspannung erzeugt werden Ikann.

Besonder bevorzugt ist jedoch, als elektrisch aktivierbare Leuchtfolie eine Folie mit organischen Leuchtdioden, eine sog. OLED-Folie zu verwenden, die den Vorteil bietet, daß sie mit einer durch eine äußerst einfache Zusatzschaltung aus einer Bord-Gleichspannung ableitbaren Gleichspannung betrieben werden kann. Die für Elektrolumineszenzfolien erfoderliche Ansteuerelektronik entfällt ebenso wie besondere Isolationsmaßnahmen. Ein weiterer Vorteil von OLED-Folien ist die wesentlich höhere erreichbare Leuchtdichte.

Die oben erwähnten sowie weitere Vorteile und Eigenschaften eines erfindungsgemäßen Schildes sind in den Unteransprüchen niedergelegt.

Die Erfindung wird im folgenden anhand eines Ausführungsbeispiels unter Bezugnahme auf die Zeichnung beschrieben; in dieser zeigen:
- Fig. 1: eine Vorderansicht eines erfindungsgemäßen Schildes, das als Kraftfahrzeug-Kennzeichenschild ausgebildet ist, und
- Fig. 2: in stark schematisierter Form einen Schnitt durch das Schild aus Fig. 1 längs der Linie II-II.

Bei dem in den Figuren gezeigten Ausführungsbeispiel ist das als Kennzeichenschild eines Kraftfahrzeugs ausgebildete erfindungsgemäße Schild 1 am Karosserieblech 2 eines Kraftfahrzeuges in nicht dargestellter Weise befestigt. ner Reflexion an der retroreflektierenden Folie 15 ohne erheblichen Intensitätsverlust durch sie hindurchtreten kann.

Diese weitere Folie 16 verhindert aufgrund ihrer rauhen Oberflächen, daß es zu einem örtlichen Ansaug- bzw. Anlegeeffekt zwischen der retroreflektierenden Folie 15 und der Innenseite der Lichtscheibe 9 kommen kann. Ohne das Vorhandensein der weiteren Folie 16 würden diese Effekte zur Bildung örtlicher, deutlich abgegrenzter dunkler Flecken oder von Newton-Ringen führen, die beim Betrachten des Schildes von außen her deutlich sichtbar wären und das Erscheinungsbild des Schildes nachteilig beeinflussen würden.

Die für den Betrachter sichtbaren, in Fig. 1 gezeigten, auf dem Schild dargestellten Symbole 20 können sich auf der Vorder- und/oder Rückseite eines Symbolträgers befinden und unterscheiden sich hinsichtlich ihrer Transparenz von den übrigen Flächenbereichen des Symbolträgers. Im vorliegenden Fall sind sie praktisch lichtundurchlässig ausgebildet, so daß sie im Vergleich zu den nahezu vollständig lichtdurchlässigen übrigen Bereichen des Symbolträgers schwarz erscheinen.

Bei dem eben erwähnten Symbolträger handelt es sich nicht notwendigerweise um ein zusätzliches Bauteil. Vielmehr können die darzustellenden Symbole auf die Vorderseite der retroreflektierenden Folie 15 oder die Vorder- oder Rückseite der weiteren Folie 16 aufgedruckt sein. Ebenso ist es möglich, die Symbole 20 auf der Innen- oder Außenfläche der Lichtscheibe 9 vorzusehen. Dort können sie auch als erhabene, d.h. über die betreffende Flachseite vorstehende Strukturen ausgebildet werden.

In Abweichung hiervon ist es allerdings auch möglich, einen in Fig. 2 nicht gezeigten zusätzlichen Symbolträger, der als flache Scheibe oder Folie ausgebildet ist, vor der retroreflektierenden Folie 15 anzuordnen.

Je nach Verwendungszweck des erfindungsgemäßen Schildes kann der Symbolträger auch mehr als zwei Transparenzstufen aufweisen. Auch können eine oder mehrere der Folien bzw. die Außen- bzw. Innenfläche der Lichtscheibe 9 in unterschiedlichen Bereichen unterschiedlich gefärbt sein, so daß sich hier weitere Gestaltungsmöglichkeiten ergeben, die insbesondere auch eine Verwendung eines erfindungsgemäßen Schildes als Verkehrsschild zulassen.

## Patentansprüche

1. Schild (1), insbesondere Kraftfahrzeug-Kennzeichenschild, mit einem Gehäuse (3), das eine flächenhafte Rückwand (4) und einen diese Rückwand (4) umgebenden, nach vorne vorstehenden Rand (5) umfaßt, der eine Lichtdurchtrittsöffnung (7) umschließt, durch die hindurch ein flacher sich parallel zur Rückwand (4) des Gehäuses erstreckender Symbolträger sichtbar ist, der zur Darstellung der auf ihm befindlichen Symbole (20) Bereiche unterschiedlicher Transparenz aufweist, wobei zur Beleuchtung zwischen der Rückwand (4) und dem Symbolträger eine elektrisch aktivierbare Leuchtfolie (14) vorgesehen ist, die zumindest die Bereiche hoher Transparenz des Symbolträgers von hinten her durchleuchtet, **dadurch gekennzeichnet,**
**daß** vor der elektrisch aktivierbaren Leuchtfolie (14) und parallel zu dieser eine sich zumindest über erhebliche Teile der Fläche der Lichtaustrittsöffnung (7) erstreckende, für das von hinten kommende Licht der elektrisch aktivierbaren Leuchtfolie (14) zumindest teilweise transparente, für von außen durch die Lichtaustrittsöffnung (7) hindurchtretendes und auf sie auffallendes Fremdlicht retroreflektierende Folie (15) angeordnet ist,
**daß** eine die Lichtaustrittsöffnung (7) verschließende, zumindest bereichsweise transparente Lichtscheibe (9) vorgesehen ist und
**daß** zwischen der Innenseite der Lichtscheibe (9) und der ihr zugewandten Oberfläche der retroreflektierenden Folie (15) eine rauhe Schicht vorgesehen ist.

2. Schild nach Anspruch 1, **dadurch gekennzeichnet, daß** die rauhe Schicht eine zwischen der retroreflektierenden Folie (15) und der Lichtscheibe (9) angeordnete, beidseitig rauhe Folie (16) umfaßt, welche sich parallel zur retroreflektierenden Folie (15) zumindest über einen wesentlichen Teil des Bereichs der retroreflektierenden Folie (15) erstreckt, der durch die Lichtscheibe hindurch sichtbar ist.

3. Schild nach Anspruch 1 oder 2, **dadurch gekennzeichnet, daß** die rauhe Schicht einen rauhen Belag auf der der Lichtscheibe (9) zugewandten Oberfläche der retroreflektierenden Folie (15) umfaßt.

4. Schild nach einem der vorhergehenden Ansprüche, **dadurch gekennzeichnet, daß** die rauhe Schicht einen rauhen Belag auf der der retroreflektierenden Folie (15) zugewandten Oberfläche der Lichtscheibe (9) umfaßt.

5. Schild nach einem der vorhergehenden Ansprüche, **dadurch gekennzeichnet, daß** die Lichtscheibe auch als Symbolträger dient.

6. Schild nach einem der Ansprüche 2 bis 4, **dadurch gekennzeichnet, daß** die rauhe Folie (16) auch als Symbolträger dient.

7. Schild nach einem der Ansprüche 1 bis 4, **dadurch gekennzeichnet, daß** die retroreflektierende Folie (15) auch als Symbolträger dient.

8. Schild nach einem der Ansprüche 1 bis 4, **dadurch gekennzeichnet, daß** ein eigenständiger Symbolträger vorgesehen ist.

9. Schild nach Anspruch 8, **dadurch gekennzeichnet, daß** der Symbolträger als eigensteife Platte ausgebildet ist.

10. Schild nach Anspruch 8, **dadurch gekennzeichnet, daß** der Symbolträger eine flexible Folie ist.

11. Schild nach einem der vorhergehenden Ansprüche, **dadurch gekennzeichnet, daß** die Folien (14, 15, 16) zwischen der Rückwand (4) des Gehäuses (3) und der Lichtscheibe (9) lose aneinander anliegend gehalten sind.

12. Schild nach einem der vorhergehenden Ansprüche, **dadurch gekennzeichnet, daß** die elektrisch aktivierbare Leuchtfolie (14) eine Elektrolumineszenzfolie ist.

13. Schild nach einem der vorhergehenden Ansprüche, **dadurch gekennzeichnet, daß** die elektrisch aktivierbare Leuchtfolie (14) eine Leuchtfolie mit organischen Leuchtdioden (OLED-Folie) ist.
